# EUROPEAN PATENT APPLICATION

(11) **EP 0 617 377 A2**
(43) Date of publication of application: **28.09.1994**
(21) Application number: 94103180.9
(22) Date of filing: 03.03.1994
(51) Int. Cl.: G06F 15/78, G11C 16/06

(54) **Microcomputer with flash memory**

(30) Priority: 20.03.1993 JP 85328/93
(71) Applicant: HITACHI, LTD., Chiyoda-ku, Tokyo 100 (JP)
(72) Inventor: Matsubara, Kiyoshi, Higashimurayama-shi, Tokyo (JP); Sato, Masanao, Suginami-ku, Tokyo (JP); Ishikawa, Eiichi, Kodaira-shi, Tokyo (JP)
(74) Representative: Strehl Schübel-Hopf Groening & Partner

(57) **Abstract**

A one-chip type microcomputer or microprocessor includes a one-time programmable flash memory (FMRY) and a central processing unit (CPU) allowed to access the flash memory. The flash memory (FMRY) further includes a plurality of electrically erasable and programmable non-volatile memory elements arranged in a matrix pattern. The non-volatile memory element is made reprogrammable by erasure and writing only when a test mode (an operation mode exclusively utilizable by manufacturers of microcomputers) is designated by an external terminal (15). On the other hand, the flash memory is set one-time programmable by writing in a non-test mode (an op-eration mode inclusively utilizable by users of microcomputers) designated by the external terminal. The one-chip microcomputer or microprocessor is sealed in a plastic package with a pin-to-pin pitch of 0.5 mm or less.

## Description

### BACKGROUND OF THE INVENTION

The present invention relates to a one-chip or single-chip type microcomputer with a built-in flash type memory having electrically erasable and programmable non-volatile memory elements and more particularly to a microcomputer to be so configured as to make user specification with respect to the flash type memory one-time programmable (information written once remains unerasable).

Japanese Laid-opened Patent Publication No. 289997/1990 discloses a flash EEPROM (Electrically Erasable and Programmable Read Only Memory). This flash EEPROM may be understood as what is similar in significance to the flash memory in the present specification. The flash memory is designed so that data can be made reprogrammable electrically by erasing/writing. As in the case of EPROM (Electrically Programmable Read Only Memory), one memory cell in the flash memory may be formed of one transistor. Therefore, the number of transistors in the memory cell of the flash memory is reducible in comparison with such an EEPROM (Electrically Erasable and Programmable Read Only Memory) that one memory cell has a memory transistor of MNOS (Metal Nitride Oxide Silicon) and a selection transistor. The flash memory functions so that a plurality of memory cells as a whole or a block of memory cells therein are erasable electrically and collectively. While the flash memory like this is actually assembled in a system, the data stored therein is rendered reprogammable a desired number of times.

Japanese Laid-opened Patent Publication No. 161469 /1989 discloses a microcomputer with EPROM (Erasable and Programmable Read Only Memory) as a programmable non-volatile memory loaded on a single semiconductor chip. The data stored in the on-chip EPROM in such a microcomputer is made erasable by ultraviolet ray irradiation. As a result, the data stored in EPROM of the microcomputer becomes unerasable after the semiconductor chip is sealed in a package to make it impossible to irradiate the package with ultraviolet rays, that is, after the package has been assembled or installed in a system. In this sense, the microcomputer may be called a one-time programmable (hereinafter simply called "OTP") microcomputer. The user of the microcomputer performs the write operation by connecting the on-chip EPROM to a write unit such as an EPROM writer using a socket adaptor before assembling the microcomputer on a circuit board.

### SUMMARY OF THE INVENTION

With respect to a microcomputer incorporating EPROM, however, writing to the EPROM can be tested only before a semiconductor chip in which the microcomputer has been formed (hereinafter also called "microcomputer chip") is sealed in a package. If, moreover, the writing test is made several times in the state of a wafer, an erase process using ultraviolet rays will have to be performed each time the test is made. In other words, it remains infeasible to make writing tests with efficiency and reliability by electrically performing the reprogram operation several times.

Consequently, the present inventors have made a study of microcomputers with an on-chip flash memory in place of EPROM. Although the data stored in the built-in flash memory of the microcomputer is electrically reprogrammable a number of times in this case, the present inventors have found there also arise the following problems.

When the flash memory is erased, there occurs the necessity of performing the pre-write operation to uniformize the write level prior to erasure and to avoid excessive erasure (a phenomenon in which the threshold voltage of the transistor in the memory cell tends to become too low and ultimately turns negative when excessive erasure is made, thus rendering normal reading impossible) which is a problem peculiar to the flash memory or of employing a technique of erasing data bit by bit while verifying the data. As a result, an erase control means for controlling the erase procedure is specifically necessary for the microcomputer having the on-chip flash memory. Since the erase technique is also required when the microcomputer is utilized while it becomes packaged in the system, the external side of the microcomputer can no way be relied upon. Therefore, the control means like this tends to occupy not a small area on the microcomputer chip. On condition that such a microcomputer is what is replaced with the OTP microcomputer, the present inventors have come to find out that the arrangement of an erase control circuit is useless because it is not utilized more than once after data is written thereto.

In the flash memory, moreover, the electric field across the source·drain becomes greater in the memory cell set in the word-line non-select and data-line select state at the time of writing, for example. This results in causing hot holes to be injected from the drain to the floating gate and there arises a data-line disturbance, as a phenomenon of causing the threshold value of the memory cell transistor to lower. Consequently, there is the possibility that data in the memory cell may inverted undesirably. The data-line disturbance becomes manifest in proportion to the length of time (i.e., the number of reprogramming times) the memory cell is exposed to the above state of voltage application. In order to guarantee writing as many as thousands ^{∼} tens of thousands of times, the microcomputer incorporating flash memory requires a circuit arrangement to counter the data-line disturbance.

The present inventors have further come to notice that since no data is written to the flash memory again once data is written thereto as long as the microcomputer to be replaceable with the OTP microcomputer is involved, the circuit used to cope with the data-line disturbance is practically useless likewise.

An object of the present invention is to provide a one-time programmable microcomputer or microprocessor with a flash memory.

Another object of the present invention is to provide a microcomputer or a microprocessor with a flash memory having a small area to be occupied by a chip.

Still another object of the present invention is to provide a one-time programmable microcomputer or microprocessor with a flash memory which is easy to use in a test mode.

These and other objects and novel features of the present invention will become more apparent by referring to the following description and appended drawings.

A brief description will subsequently be given of an exemplary embodiment of the invention as disclosed in the present application for a patent.
(1) A one-chip type microcomputer or microprocessor according to the present invention includes a one-time programmable flash memory and a central processing unit capable of gaining access to the flash memory. The flash memory includes a plurality of electrically erasable and programmable non-volatile memory elements arranged in a matrix pattern, the memory element being made reprogrammable by erasing and writing only when a test mode (an exclusive operation mode to be utilized by the microcomputer manufacturer) is designated by an external terminal. On the other hand, the flash memory is made one-time programmable or programmable only when a non-test mode (an inclusive operation mode to be utilized by the microcomputer user) is designated by the external terminal.
(2) With respect to the erasure required only in the test mode, there is provided a logic means for controlling erase voltage application time during which the non-volatile memory element is erased in proportion to a period during which the signal supplied to the predetermined external terminal remains in a fixed state. A series of steps to apply erase voltage is arranged so that they are controlled from the outside of the microcomputer. In this way, the scale of the circuit involve in erasing the flash memory is reduced.
(3) A one-chip type microcomputer or microprocessor according to the present invention includes a one-time programmable flash memory and a central processing unit capable of gaining access to the flash memory. The flash memory includes a plurality of electrically erasable and programmable non-volatile memory elements arranged in a matrix pattern, the memory element being made reprogrammable by erasing and writing only when a test mode is designated by an external terminal. In the non-test mode designated by the external terminal, a part of the above memory element can be written only.
(4) The flash memory is provided with write control means for controlling a series of write steps in write voltage application so as to effect the write operation in the test and non-test modes both. In order to enhance user-friendly write control in the non-test mode, the microcomputer or microprocessor is provided with a control register for giving the write control means a write operation. The control register is set accessible by the CPU.
(5) As it is necessary to repeat the operation of reprogramming (defined as data-writing after erasure of data) the non-volatile memory element several times in the test mode, the circuit arrangement for coping with the data disturbance is unnecessary for the flash memory.

With the means above, the following effect will be achievable:
It is possible to electrically test writing to the built-in flash memory a plurality of times to guarantee erasure and writing electrically in the test mode. In comparison with the microcomputer incorporating the one-time programmable EPROM which allows only ultraviolet-ray erasure, the microcomputer according to the present invention is easy to use in the test mode and the writing test can be made after the microcomputer chip has been sealed in a package.

To allow only writing in the non-test mode functions as what is to guarantee writing several times even in the test mode and this makes it possible to exclude a circuit arrangement to cope with the data-line disturbance from the built-in flash memory.

With respect to the erasure required in only the test mode, any user-friendly procedure need not be taken into consideration, so that the erase voltage application time in erasing the non-volatile memory element is controlled in proportion to the period during which the signal supplied to the predetermined external terminal remains in a fixed state. The scale of the erase circuit utilized in only the test mode is reduced by externally controlling a series of erase procedures.

When-negative voltage is used for erasure, further, a negative voltage generating circuit is unnecessary to provide internally because the negative voltage should be supplied directly from the outside. Therefore, the ratio of the area of the microcomputer chip to what is occupied by the flash memory and the control circuit related thereto is reducible and consequently the cost of the one-chip type microcomputer or microprocessor is reduced. Since an additional circuit may be formed in a chip surface portion corresponding to the reduced portion of the area occupied by the flash memory and the control circuit related thereto, the function of the one-chip type microcomputer or microprocessor can be enhanced.

### BRIEF DESCRIPTION OF THE DRAWINGS

Fig. 1 is a block schematic diagram of a one-time programmable microcomputer embodying the present invention.

Fig. 2 is a diagrammatic illustration of the form of writing to a flash memory on the part of a user.

Fig. 3 is a detailed block diagram of a microcomputer embodying the present invention.

Fig. 4 is a top view of a flat package obtained by sealing the microcomputer of Fig. 3 with resin.

Fig. 5(A) is a diagram illustrating the structure of a flash memory cell.

Fig. 5(B) is a graphic representation of the written and erased state of the flash memory.

Fig. 6 is a block diagram illustrating the formation of a memory cell array using the transistor of Fig. 5(A).

Fig. 7 is a table of exemplary voltage conditions under which the erase and write operations are performed for the memory cell.

Fig. 8 is an exemplary circuit diagram of the flash memory.

Fig. 9 is a logic diagram illustrating the logic of forming an ERASE signal in the flash memory of Fig. 8.

Fig. 10 is an exemplary flowchart showing erase operation procedure for the flash memory of Fig. 8.

Fig. 11(A) is a diagrammatic illustration of a write control register.

Fig. 11(B) is a table of output voltages in the respective operation modes of a voltage selection circuit VSEL.

Fig. 12 is an exemplary flowchart showing write control procedure for the flash memory of Fig. 8 together with Fig. 13.

Fig. 13 is an exemplary flowchart showing write control procedure for the flash memory of Fig. 8 together with Fig. 12.

Fig. 14 is an exemplary circuit diagram of another flash memory.

Fig. 15(A) is a diagrammatic illustration of a write/erase control register.

Fig. 15(B) is a table of output voltages in the respective operation modes of a voltage selection circuit VSEL.

Fig. 16 is an exemplary flowchart showing erase control procedure in an erase control circuit.

### DETAILED DESCRIPTION OF THE PREFERRED EMBODIMENT

An embodiment of the present invention will be described with the following headings in order.
[1] General Description of OTP Microcomputer;
[2] Detailed Description of OTP Microcomputer;
[3] Principle of Flash Memory;
[4] Built-in Flash Memory (1);
[5] Erase Control (1);
[6] Write Control;
[7] Built-in Flash Memory (2);
[8] Erase Control (2).

### [1] General Description of OTP Microcomputer:

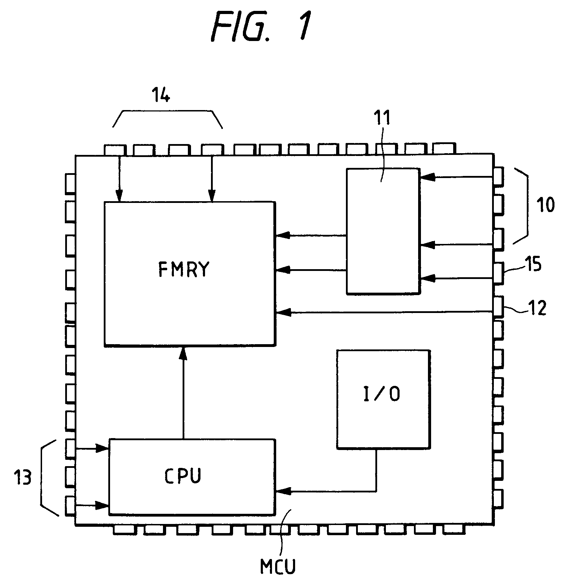

Fig. 1 is a block schematic diagram of a microcomputer (microprocessor) incorporating a one-time programmable (OTP) flash memory embodying the present invention. The microcomputer MCU of Fig. 1 comprises a central processing unit CPU, a flash memory, a peripheral I/O circuit and the like on a single semiconductor chip. The MCU is sealed in, though not necessarily limited to, a flat package of a both package type in which the pin pitch has been reduced to as fine as 0.5 mm or less after the device test is completed in its wafer state. As will be described in detail later, the flash memory FMRY includes a plurality of electrically erasable and programmable non-volatile memory elements to be arranged in a matrix pattern. In the flash memory FMRY, the memory element is made reprogrammable (the reprogramming is defined as writing data after erasing data) by erasing and writing only when a test mode (an exclusive operation mode that the microcomputer manufacturer may utilize) is designated by the external terminal. The flash memory FMRY is made one-time programmable where only writing is possible in a non-test mode (an inclusive operation mode open to the public so that microcomputer users may utilize it). In the non-test mode, CPU (Central Processing Unit) exexutes predetermined data processing by reading the data stored in the flash memory FMRY. That is in the non-test mode, the writing to the flash memory FMRY and the reading from the flash memory FMRY are possible.

In Fig. 1, numeral 10 denotes external terminals for receiving n-bit signals for designating the operation mode of the microcomputer MCU, the mode signals being commonly applied to a predetermined logic means 11, which applies to each unit a control signal corresponding to its operation mode. Further, numeral 12 denotes an input terminal for receiving a voltage of as high as 12 V to be supplied to the flash memory FMRY. The test mode set by the external terminal 10 is an operation mode in which a predetermined internal circuit module can be accessed directly from the outside and tested or otherwise a predetermined built-in circuit module is operated and tested not under the control of the CPU.

When the manufacturer of the microcomputer MCU tests writing to the flash memory FMRY in the wafer state or in the state in which it has been sealed in a package (though the packaged state is shown in Fig. 1 by way of example, the pins of the package in the wafer state are made to correspond to respective connection electrodes such as bonding pads), the microcomputer MCU is connected to an external tester. The operation mode of the microcomputer MCU is set to the test mode, depending on the combination of levels of the mode signal supplied from the tester to the external terminal. Then a signal or information for designating the write operation and the write data is supplied from the tester to the predetermined external terminal of the microcomputer MCU.

When the write voltage application time and the procedure for the write verify operation are to be controlled by software, for example, the CPU receives the write commands generated by the tester from terminals 13, sequentially controls the write operation procedure and writes the write data to the flash memory FMRY according to a write control program.

When the operating procedure is controlled by software for special use, on the other hand, the control circuit (contained in the circuit block of the flash memory FMRY in Fig. 1) gains instructions as to the write operation directly from external terminals 14 or a logic means in accordance with the set operation mode, or via the CPU. The procedure for the write operation is sequentially controlled in accordance with the control circuit logic and write data is written to the flash memory FMRY.

After the step of writing to one address in the flash memory FMRY is taken, the tester reads data from the address in the flash memory FMRY. Then the tester performs the verify operation for deciding whether or not the data that has been read conforms to write data. When it is decided that the write data is not in conformity with the read data in the verify operation, the step of writing is taken at the same address again. If the write data conforms to the read data in the verify operation, the step of writing to the next address in the flash memory FMRY.

The data written to the flash memory FMRY is erased as follows, for example.

First, the tester supplies to the external terminal 10 a signal for designating the erase operation in the test mode. Then the tester supplied an input signal to a predetermined external terminal 15. High erase voltage application time is controlled by the time during which the input signal applied to the external terminal 15 is kept at a predetermined potential level. In other words, the erase procedure is controlled by the tester and data in the whole or each block of memory cells of the flash memory FMRY are collectively erased. This operation is repeated when necessary, whereby the test of writing to the flash memory FMRY is completed.

Any specification related to erasure including the aspect of the operation mode for erasure, the specification of the erase command, the location of the terminal 12 for controlling erase time, and the specification of signal timing to be supplied to the terminal is not disclosed to users. Consequently, the flash memory FMRY is one-time programmable as far as the user specification is concerned.

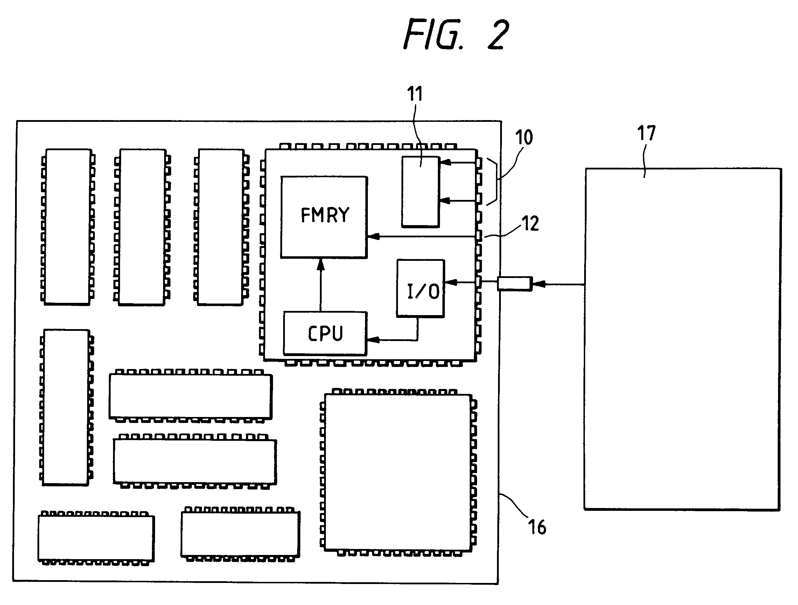

Writing to the flash memory FMRY in the microcomputer MCU on the part of the user is performed in such a state, though not necessarily limited to, that the microcomputer MCU sealed in a package is packaged and fixed to a circuit board 16 as shown in Fig. 2. The microcomputer MCU on the circuit board 16 is set via the external terminals 10 to the non-test mode and a high voltage is applied thereto from the external terminal 12.

When the write voltage application time and the procedure for the write verify operation are controlled by software, for example, the write command is given via the predetermined I/O circuit to the CPU from a computer (workstation, personal computer, etc.) 17 utilized by the user for writing. Accordingly, the CPU sequentially controls the write operation according to the write control program, so that the write data is written to the flash memory FMRY.

When the write voltage application time and the procedure for the write verify operation are controlled by-hardware (control circuit), the write operation is designated directly to the control circuit from the outside or via the CPU and while the procedure for the write operation is sequentially controlled in accordance with the logical operation of the control circuit, the write data is written to the flash memory FMRY.

In connection with writing on the part of the user, the writing is allowed in not only the packaged state of the microcomputer MCU on the circuit board 16 but also such a state that the microcomputer MCU is fitted via a socket adaptor to a write device such as a general-purpose PROM writer. In this case, the microcomputer MCU is so designed as to support the PROM writer write mode in the non-test mode. More specifically, as shown in Fig. 1, it is only necessary for a programmable operation mode to be set in the non-test mode via the terminal 13 or 14.

However, there is the possibility that any one of the pins may be bent when a microcomputer package is fitted to a socket adaptor on condition that the microcomputer is sealed in a package with pins pitched as fine as 0.5 mm or less. This means that the PROM writer write mode in the non-test mode may not practically be utilized by the user. If, conversely, there is no possibility for the pin to be bent, it may also be considered advantageous to the user that a single microcomputer body is used to write data to the built-in flash memory in the PROM writer write mode. This is because even if any defective data is written to the flash memory, it is allowed not to discard the whole circuit board.

The provision of the built-in flash memory FMRY and that of the user specification as OTP make the following effect achievable.
(1) It is possible to electrically test writing to the built-in flash memory a plurality of times to guarantee erasure and writing electrically in the test mode. In comparison with the microcomputer incorporating the one-time programmable EPROM which allows only ultraviolet-ray erasure, the microcomputer according to the present invention is easy to use in the test mode. Moreover, the test of writing to the flash memory EMRY can be made after the microcomputer chip has been sealed in a package.
(2) To allow only writing to the flash memory FMRY in the non-test mode functions as what is to guarantee writing several times even in the test mode and this makes it possible to exclude a circuit arrangement to cope with the data-line disturbance from the built-in flash memory. In other words, the circuitry of the flash memory FMRY can be designed without taking measures to cope with the data-line disturbance.
(3) With respect to the erasure required in only the test mode, since any user-friendly procedure need not be taken into consideration, there is provided the logic means 11 for controlling the erase voltage application time in erasing the non-volatile memory element in proportion to the period during which the signal supplied to the predetermined external terminal 12 remains in a fixed state. The scale of the erase circuit utilized in only the test mode can thus be reduced by externally controlling a series of procedures for applying the erase voltage.

### [2] Detailed Description of OTP Microcomputer:

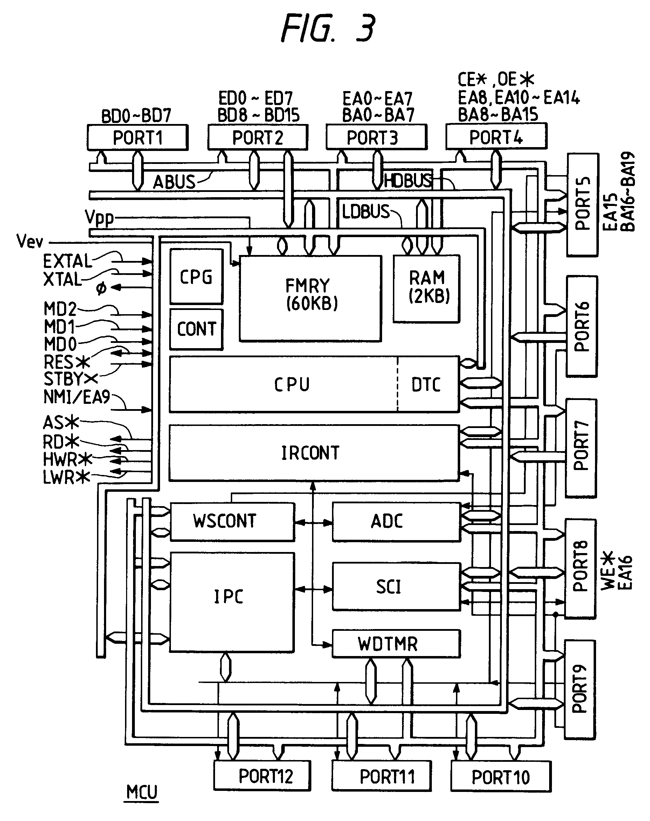

Fig. 3 is a block diagram of a microcomputer embodying the present invention. The microcomputer (microprocessor) MCU shown in Fig. 1 has circuit modules including the central processing unit (CPU), a flash memory FMRY, a serial communication interface SCI, a control circuit CONT, a data transfer controller DTC, a random access memory RAM, a 16-bit integrated timer pulse unit IPU, a watch dog timer WDTMR, PORTs 1 to 12, a clock generator CPG, an interrupt controller IRCONT, an analog to digital converter ADC, and a wait state controller WSCONT.

These circuit modules are formed on one silicon semiconductor board through, though not necessarily limited to, known semiconductor integrated circuit technology. The CPU, the flash memory FMRY, the random access memory RAM and the 16-bit integrated timer pulse unit IPU are connected to an address bus ABUS, a low-order data bus LDBUS (e.g., 8 bits) and an high-order data bus HDBUS (e.g., 8 bits). The serial communication interface SCI, the watch dog timer WDTMR, the interrupt controller IRCONT, the analog to digital converter ADC, the wait state controller WSCONT and the PORTS 1 to 12 are connected to the address bus ABUS and the high-order data bus HDBUS. Although not shown in Fig. 3 so as to make the drawing less complicated, the microcomputer therein has a control bus for supplying control signals such as read and write signals from the CPU to the respective modules (FMRY, RAM, IPU, SCI, WDTMR, IRCONT, ADC, WSCONT).

In Fig. 3, Vpp represents a high voltage for writing to the flash memory FMRY, EXTAL and XTAL signals applied from an oscillator externally fitted to the chip of the microcomputer MCU to the clock generator CPG, φ a synchronizing signal sent out of the clock generator CPG, RES* (the symbol * signifies a low enable signal) a reset signal, and STBY * a stand-by signal, the RES* and STBY* being supplied to the CPU and any other circuit modules. Further, NMI represents a non-maskable interrupt signal for giving a non-maskable interrupt to the interrupt controller IRCONT. Any one of the interrupt signals is given via the PORTS 8 and 9 to the interrupt controller IRCONT. Further, AS* represents an address strobe signal for indicating an effective period of the address signal which is output outside, RD* a read signal for notifying a read cycle outside, HWR* an upper-byte write signal for notifying an upper 8-bit write cycle to an external unit, and LWR* a lower-byte write signal for notifying a lower 8-bit write cycle outside, these being access control signals with respect to the external unit of the microcomputer MCU.

MD0 to MD2 represent mode signals to be supplied to the control circuit CONT for setting the operation mode of the microcomputer MCU 3. The operation modes set by the mode signals are broadly divided into test and non-test modes. The non-test modes include, but not necessarily limited to, an operation mode (hereinafter simply called "normal mode" likewise) concerning an address space controllable by the CPU such as a maximum or minimum mode, and an operation mode (hereinafter simply called "PROM writer write or program mode" like-wise) which enables the PROM writer to write data to the built-in flash memory FMRY 2. In contrast to the PROM writer write mode, the maximum or minimum mode may be understood as an operation mode for enabling the CPU 10 to program the built-in flash memory FMRY 2 in the on-board state of the microcomputer MCU 3.

In the normal mode, the PORTs 1 and 2, though not necessarily limited to these, are assigned for the input/output of data BD0 to BD15 for the microcomputer MCU to gain access to the outside. The PORTs 3 to 5 inclusive, though not necessarily limited to these, are assigned for the output of address signals BA0 to BA19 at this time.

When the PROM writer write mode is set in the microcomputer MCU, on the other hand, the PORTs 2 to 5 and 8, though not necessarily limited to these, are assigned for connecting the flash memory FMRY to the program-controlling PROM writer. In other words, the PORT 2 is assigned for command writing, the input/output of data ED0 to ED7 for writing and verifying, whereas the PORTs 3 to 5 and 8 are assigned for the input of address signals EA0 to EA16 and that of an access control signal CE* (chip enable signal), OE* (output enable signal) and WE* (write enable signal). The chip enable signal CE* is a chip selection signal from the PROM writer. The output enable signal OE* is a signal for designating the output operation with respect to the microcomputer MCU. The write enable signal WE* is a signal for designating the write operation with respect to the microcomputer MCU.

In this case, the input terminal of the signal NMI is assigned for the input of 1-bit EA9 among the address signals EA0 to EA16. The external terminals of the PORTs thus assigned and any other necessary external terminal such as the high voltage Vpp applied terminal are connected to the PROM writer via socket adapters (not shown) as sockets for converting the pin arrangement. The group of external terminals of the microcomputer MCU which are assigned for the connection to the PROM writer in the PROM writer program mode is assigned to function otherwise in other operation modes.

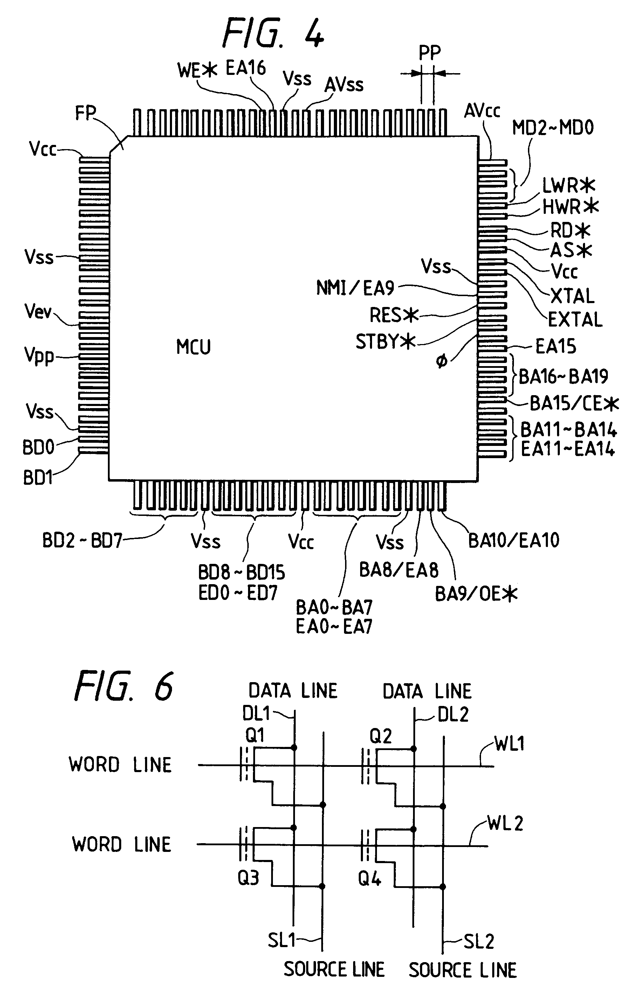

Fig. 4 is a top view of a flat package FP having external terminals in four directions as a result of sealing the microcomputer MCU with resin, for example. The signals shown in Fig. 4 are common to those in Fig. 3. The external terminals (pins) without signal names are utilized as wait signal input pins, bus request signal input pins, bus acknowledge signal output pins, signal input/output pins between the peripheral circuit such as the serial communication interface SCI and the outside and so forth.

With reference to the package FP of Fig. 4, the space between the terminals (pins) drawn out of the package FP may be 0.5 mm or less. If the terminal-to-terminal space (pin pitch) PP of the package FP is set at 0.5 mm or less when the user of the microcomputer MCU writes data to the flash memory FMRY by connecting the flash memory FMRY in the microcomputer MCU via the converter sockets to the PROM writer, the pin tends to bend because of the undesirable contact of the external terminal of the package FP with the converter socket SOCKET when the package FP is fitted into the converter socket. The pin that has been bent like this may cause defective connection when the microcomputer MCU is assembled by soldering on a printed circuit board.

Since the CPU is allowed to write data to the flash memory FMRY according to the present invention, the user is able to write data to the flash memory FMRY without using the external PROM writer. In other words, the user is expected to writhe data to the flash memory FMRY using the CPU after assembling the microcomputer MCU on the board (printed circuit board), whereby even though the microcomputer MCU has been sealed in the package with a pin-to-pin pitch of 0.5 mm or less, the external terminal drawn from the package is prevented from bending. Incidentally, semiconductor manufacturers are in possession of automatic handlers to ensure that microcomputers MCU are tested without causing pins to bend even if they are sealed in packages with a pin-to-pin pitch of 0.5 mm or less.

### [3] Principle of Flash Memory:

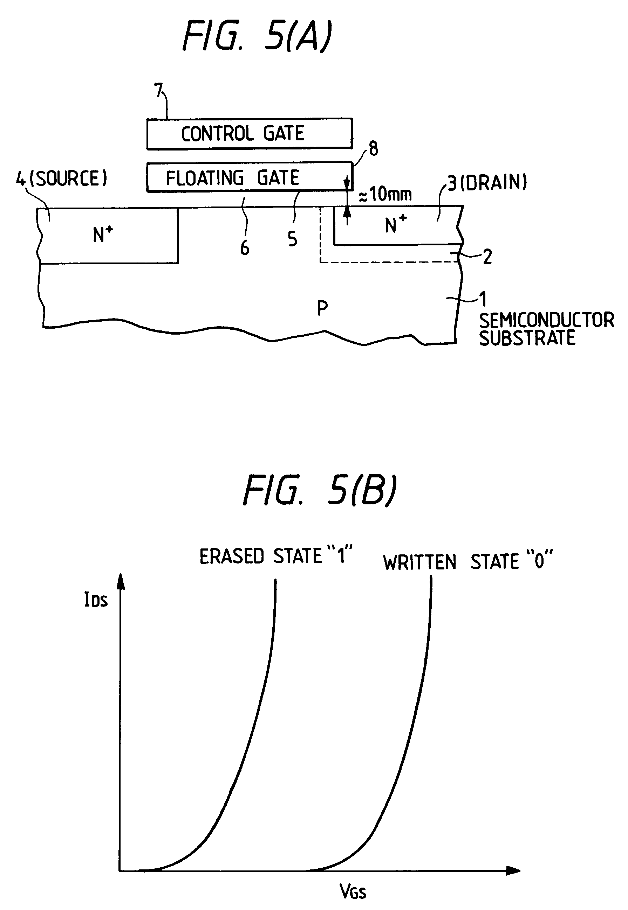

Fig. 5(A) and (B) illustrate the principle of a flash memory. The memory cell shown in Fig. 5(A) by way of example is formed with an insulated gate field effect transistor having a two-layer gate structure. In Fig. 5(A), numeral 1 denotes a P-type silicon substrate, 2 a P-type semiconductor region formed in the silicon substrate, 3, 4 N-type semiconductor regions, 5 a floating gate formed on the P-type silicon substrate 1 via a thin oxide film 6 (e.g., 10 nm thick) as a tunnel insulating film, and 7 a control gate formed on the floating gate 5 via an oxide film 8. The source is formed of the N-type semiconductor region 4, whereas the drain is formed of the N- and P-type semiconductor regions 3, 2. The data stored in this memory cell is held in the transistor substantially as variations of the threshold voltage. A description will subsequently be given of a N-channel type transistor (hereinafter also called "memory cell transistor") for storing data in the memory cell unless otherwise referred to.

The operation of writing data to the memory cell is accomplished by, for example, applying a high voltage to the control gate 7 and the drain, and avalanche-injecting electrons into the floating gate 5 from the drain side. With this write operation, the memory transistor has, as shown in Fig. 5(B), a threshold voltage higher than what is in the erased state without the write operation applied thereto as viewed from the control gate 7.

On the other hand, the erase operation is accomplished by, for example, applying a high voltage to the source to extract electrons from the floating gate 5 toward the source side by utilizing the tunnel effect. As shown in Fig. 5(B), the erase operation results in reducing the threshold voltage of the memory transistor as viewed from the control gate 7. In Fig. 5(B), the threshold value of the memory cell transistor is set at a positive voltage level in either write or erase state.

More specifically, the threshold voltage is set high in the write state against the word line selection level given to the control gate 7 from the word line, whereas the threshold voltage is held low in the erase state. With the relation thus maintained between the threshold voltage and the word line selection level, the memory cell can be formed with one transistor without the adoption of a selection transistor. When the data thus stored is electrically erased, it is erased by extracting the electrons accumulated in the floating gate 5 into the source electrode. If the erase operation is continued for a relatively long time, the quantity of electrons to be extracted tends to become greater that what has been injected into the floating gate 5 at the time of writing. If excessive erasure is electrically continued for a relatively long time, the threshold voltage level of the memory cell transistor may turn negative, thus causing such inconvenience as to allow data to be selected even at the non-select level of the word line. The write operation as well as the erase operation may be performed by making use of the tunnel current likewise.

In the read operation, the voltage applied to the drain and the control gate 7 is restricted to a relatively low level so as to prevent weak writing to the memory cell, that is, to prevent carriers from being injected into the floating gate 5 undesirably. For example, a voltage of as low as about 1 V is applied to the drain, whereas a voltage of as low as about 5 V is applied to the control gate 7. These applied voltages are used to detect the intensity of the channel current flowing through the memory cell transistor and consequently to distinguish between the logical values "0" and "1" of the data stored in the memory cell.

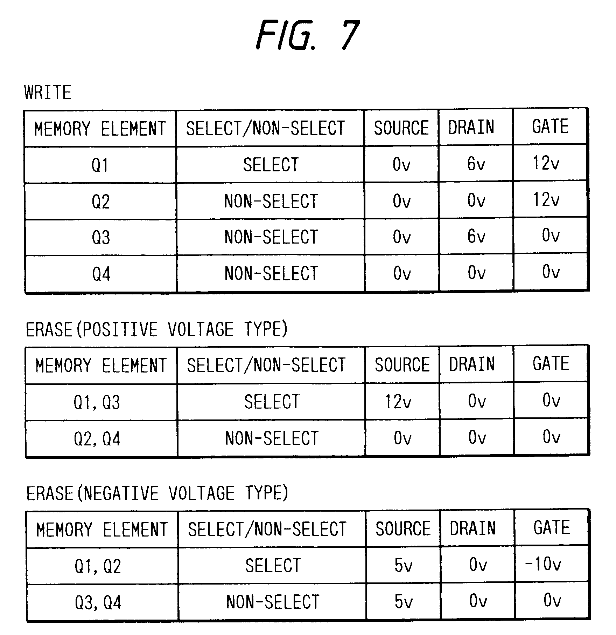

Fig. 6 illustrates the principle of forming a memory cell array using the above memory cell transistors. In Fig. 6, there are shown four memory cell transistors Q1 to Q4 by way of example. The control gates (selection gates) of memory cell transistors Q1, Q2 (Q3, Q4) arranged on the same line in the matrix memory cells in directions of X and Y are connected to a corresponding word line WL1 (WL2). The drain regions (input/output nodes of the memory cell) of the memory cell transistors Q1, Q3 (Q2, Q4) arranged on the same column are connected to a corresponding data line DL1 (DL2). The source regions of the memory cell transistors Q1, Q3 (Q2, Q4) are coupled to a corresponding source line SL1 (SL2).

Fig. 7 is a table of exemplary voltage conditions under which the erase and write operations are performed for the memory cell. In Fig. 7, the memory element means a memory cell transistor and the gate a control gate as the select gate of the memory cell transistor. Referring to Fig. 7, a high electric field necessary for erasing the negative voltage system is formed by applying a negative voltage of, for example, -10 V to the control gate. As is obvious from the voltage conditions shown in Fig. 7 by way of example, at least the memory cells to which the source has commonly been connected can collectively be erased in the positive voltage system. In the arrangement shown in Fig. 6, four of the memory cells Q1 to Q4 are collectively erasable on condition that the source lines SL1, SL2 are connected together. In reference to the source line division system, there is a case where the word line is set as a unit (the common source line is extended in the direction of the word line) in addition to a case as representatively shown in Fig. 6 where the data line is set as a unit. On the other hand, the memory cells to which the control gates have commonly been connected are collectively erasable when the negative voltage system is erased.

### [4] Built-in Flash Memory (1):

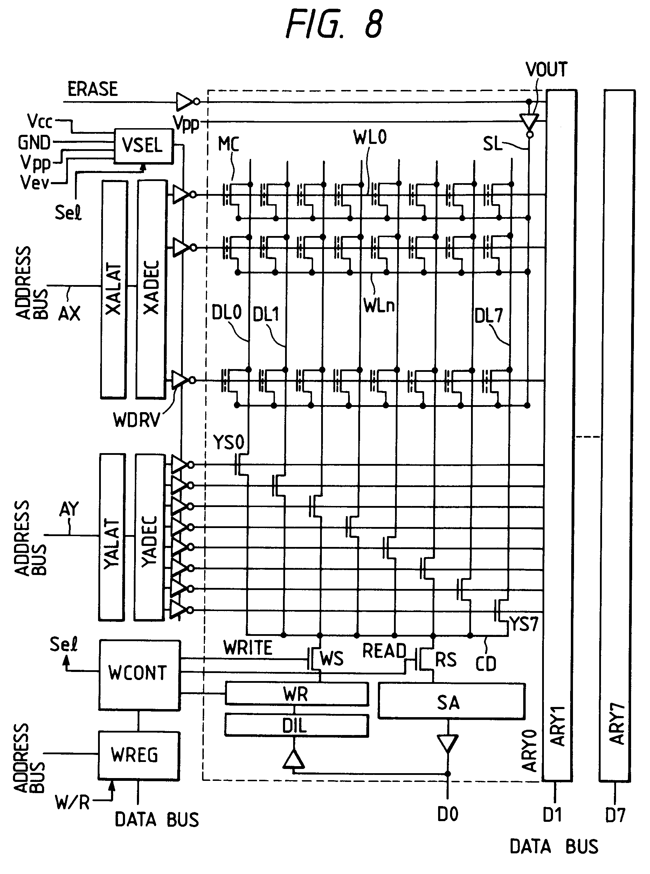

Fig. 8 is an exemplary circuit diagram of the flash memory FMRY. The flash memory FMRY 1 shown in Fig. 8 has 8-bit data input/output terminals D0 ^{∼} D7, each having memory arrays ARY0 ^{∼} ARY7. Each of the memory arrays ARY0 ^{∼} ARY7 is arranged in the same way.

In each of the memory arrays ARY0 ^{∼} ARY7 exist matrix memory cells MC formed with the respective insulated gate field effect transistors of the two-layer gate structure as described in Fig. 5(A). In Fig. 8, WL0 ^{∼} WLn represent word lines common to all of the memory arrays ARY0 ^{∼} ARY7. The control gates of the memory cells arranged on the same line are connected to the corresponding word lines. In the memory arrays ARY0 ^{∼} ARY7, the drain regions of the memory cells MC arranged on the same line are connected to the corresponding data lines DL0 ^{∼} DL7. The source regions of the memory cells MC are commonly connected to the respective source lines SL.

The high voltage Vpp for use in erasing data is supplied from a voltage output circuit VOUT such as a clock invertor circuit to the source line SL. The output operation of the voltage output circuit VOUT is controlled by an ERASE signal. In other words, the voltage output circuit VOUT supplies a high voltage necessary for erasure to all of the source regions of the memory cells by supplying the high voltage Vpp to the source line SL during the high level period of the ERASE signal, whereby the flash memory FMRY is allowed to collectively erase the whole memory cell.

The selection of the word line WL0 ^{∼} WLn is made by making an X address decoder XADEC decode the X address signal taken in via an X address latch XALAT. A word driver WDRV drives the word line on the basis of the select-signal output from the X address decoder XADEC. In the data-read operation, the word driver WDRV is operated with a voltage Vcc of 5 V supplied from a voltage selection circuit VSEL and a ground potential GND of 0 V as a power source. The word driver WDRV simultaneously drives a word line to be selected up to a selection level by means of the voltage Vcc and also maintains the word line to be selected at the non-select level such as that of the ground potential. In the data-write operation, the word driver WDRV is operated with a voltage Vpp of 12 V supplied from the voltage selection circuit VSEL and a ground potential GND of 0 V as a power source. The word driver WDRV simultaneously drives a word line to be selected up to a write voltage level of as high as 12 V. In the data erase operation, the output of the word driver WDRV is set at a voltage level of as low as 0 V. At the time of verifying erasure in the data erase operation, the voltage selection circuit VSEL supplies an erase verify voltage Vev, which will be described below, to the word driver WDRV.

The data lines DL0 ^{∼} DL7 in the memory arrays ARY0 ^{∼} ARY7 are connected via respective selection switches YS0 ^{∼} YS7 to a common data line CD. The selection switches YS0 ^{∼} YS7 are controlled by a Y-address decoder which decodes a Y-address signal AY fed via a Y-address latch YALAT. The output selection signals of the Y-address decoder YADEC are commonly supplied to all the memory arrays ARY0 ^{∼} ARY7. Therefore, one data line is connected to the common data line CD in the memory arrays ARY0 ^{∼} ARY7 when one of the output selection signals of the Y-address decoder YADEC is set at a selection level.

The data read onto the common data line CD from memory cell MC is supplied via a selection switch RS to a sense amplifier SA, where the data is amplified before being sent via a data output buffer DOB to the data bus. The selection switch RS is set at a selection level in synchronization with the read operation. The write data supplied from the outside is held in a data input latch DIL via a data input buffer DIB. When the data held in the data input latch DIL is "0", a write circuit WR supplies a high write voltage via a selection switch WS to the common data line CD. The high write voltage is supplied via the data line selected by the Y-address signal AY to the drain of the memory cell whose control gate has been supplied with a high voltage by an X-address signal AX, whereby the data is written to the memory cell involved. The selection switch WS is set at the selection level in synchronization with the write operation. Varieties of write timing and write procedures for selectively controlling the voltage are controlled by a write control circuit WCONT. A write control register WREG gives to the write control circuit WCONT instructions as to the write and verify operations. As shown in Fig. 8, the write control circuit WCONT applies a selection control signal sel to a voltage selection circuit VSEL at the time of write operation, the write verify operation and the erase verify operations. The voltage selection circuit VSEL selectively supplies a desired voltage to a desired word line, as will be described below, in response to the selection control signal sel.

### [5] Erase Control (1):

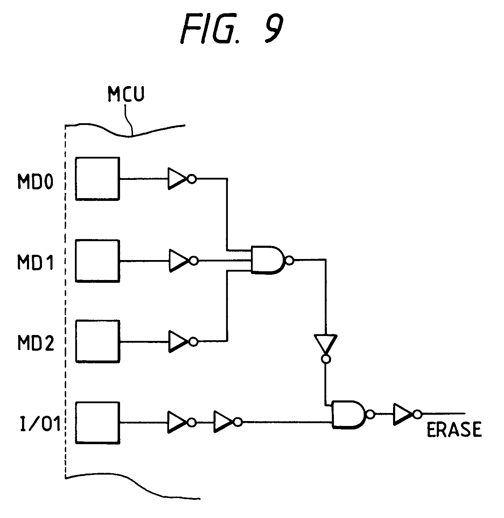

The erase control in the flash memory FMRY of Fig. 8 is effected by an external tester in the test mode. Fig. 9 illustrates an exemplary logic circuit for forming an ERASE signal.

When the test mode is set by reducing all the mode signals MD0 ^{∼} MD2 to 0, the flash memory is made accessible directly from the outside. When a high-level signal is supplied from the predetermined external terminal that has not been disclosed to the user, that is, the terminal I/O 1 of the input/output PORT 12, for example, the signal keeps the ERASE signal at a high level for a duration corresponding to the period during which the former is kept at the high level. The state in which all of the mode signals MD0 ^{∼} MD2 are reduced to 0 is designated, but not necessarily limited, by the operation mode in which the flash memory FMRY is erased in the test mode.

Although the principle of forming only the ERASE signal is shown in Fig. 9, the mode signals MD0 ^{∼} MD2 are also supplied to a signal-forming logic circuit (not shown) for controlling various operation modes (setting of the maximum or minimum mode as the normal mode or the PROM writer write mode). The illustration of that logic circuit will be omitted as it seems irrelevant to the embodiment of the present invention.

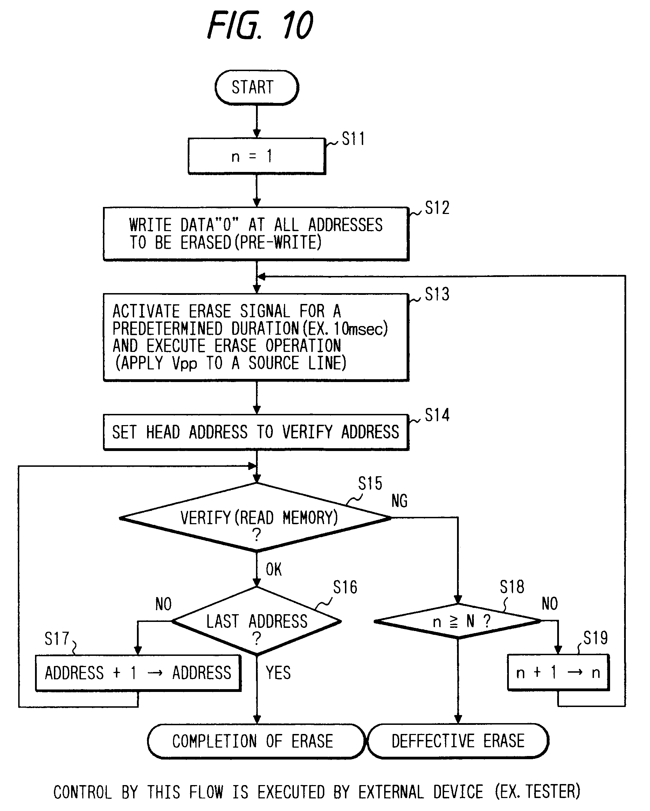

Fig. 10 is an exemplary flowchart showing erase operation procedure, which is directly controlled by the tester.

First, the tester reduces all of the mode signals MD0 ^{∼} MD2 to 0 and designates the operation mode for erasing the flash memory FMRY in the test mode. Then the tester sets 1 in its built-in counter n when effecting erasure (Step S11). The tester executes pre-writing at all addresses to be erased (Step S12), that is, writes data "0" at all addresses to be erased. This pre-write control procedure can be implemented by applying a write control procedure as will be described below. This pre-write process is performed so as to uniformize the erase state by uniformizing the charge quantity in floating gates in connection to the whole bit.

Subsequently, the tester supplies a signal to the terminal I/O 1 to make the ERASE signal active (high level) for a predetermined duration, for example, 10 msec. and collectively erases all the memory cells by applying the high voltage Vpp to the source line SL of the memory cell MC (Step S13).

Then the tester internally sets the head address of the memory cell as what is to be verified to confirm the erase state (Step S14) and so verifies the address (Step S15). In other words, by executing the memory write at an address to be verified and applying the erase verify voltage Vev to a word line to be selected at the address, the data in the erased memory cell is read out. In this case, the erase verify voltage is set at 3.5 V, which is lower than the supply voltage Vcc at 5 V, for example, to ensure a satisfactory erase level. The tester thereby verifies whether the data thus read conforms to what has completely been erased.

When the tester 10 verifies the above conformity through the verify operation, it decides whether the verified address is the last address of the memory address thus erased (Step S16) and if it is the last address, a series of erase operations is terminated. If it is decided that the last address has not yet been reached, the verified address is incremented by one (Step S17) and the process starting with Step S15 is repeated.

When the tester otherwise verifies the disparity through verification at Step S15, it decides whether or not the value in the counter n successively reaches the number of upper limit erase times N (Step S18). If the number of upper limit erase times N has been reached sequentially , the step in the flowchart is terminated as defective erase, whereas if the number of upper limit erase times N has not yet been reached sequentially, the tester increments the counter value n by one (Step S19) and repeats the process starting with the step S13.

In order to prevent excessive erasure in which it may make negative the threshold voltage value of the memory cell, erasure is made successively at a time of as short as 10 msec. while verification is effected every time.

In this case, an erase verify power supply circuit may be used to lower a power supply voltage of 5 V up to an erase verify voltage Vev of 3.5 v above. However, the input function of the erase verify voltage Vev is assigned to a particular external terminal (see Fig. 4) in the test mode according to the present invention because the erasure of data from the flash memory is only conducted in the test mode for the device test on the part of the manufacturer. Consequently, the erase verify power supply circuit can be dispensed with in the microcomputer chip. Otherwise, the erase verify voltage input function may also be dispensed with by setting the power supply voltage of the microcomputer chip at 3.5 V when erasure is verified.

### [6] Write Control:

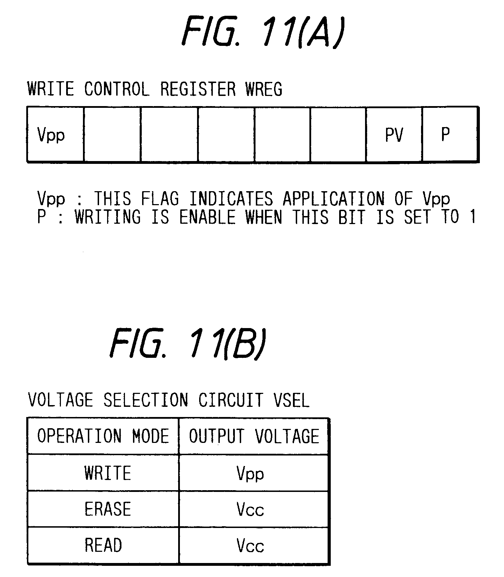

The write control procedure in both the test and non-test modes is simultaneously effected by the write control circuit WCONT. Under the control of the write control circuit WCONT, the write control register WREG is referred to. The write control register WREG has Vpp, PV and P bits as shown in Fig. 11(A). Fig. 11(B) is a table of output voltages in the respective operation modes of the voltage selection circuit VSEL. The application of the high reprogram voltage makes the Vpp bit a high voltage application flag of "1". The P bit is made the designation bit of the write operation (program operation) and the PV bit is made the designation bit of the verify operation at the time of writing. When the Vpp, PV and P bits are set, the write control circuit WCONT properly controls the write and the write verify operating procedures by reference to the Vpp, PV and P bits.

In the test mode, the write control register WREG is accessed by the tester via a predetermined external terminal and in the non-test mode, on the other hand, it is accessed by the CPU or the external unit 17. The CPU or the external unit 17 will be also called a main write control unit. The write control register WREG is coupled to the address bus ABUS and the data buses HDBUS, LDBUS. Writing data to the write control register WREG is effected by supplying the address signal of the write control register WREG to the address bus, setting the write/read control signal (W/R) at a level where writing is designated and then supplying the write data to the data bus. Reading data to the write control register WREG is also effected by supplying the address signal of the write control register WREG to the address bus, and setting the write/read (W/R) control signal at a level where reading is designated, whereby the data stored in the write control register WREG is supplied onto the data bus.

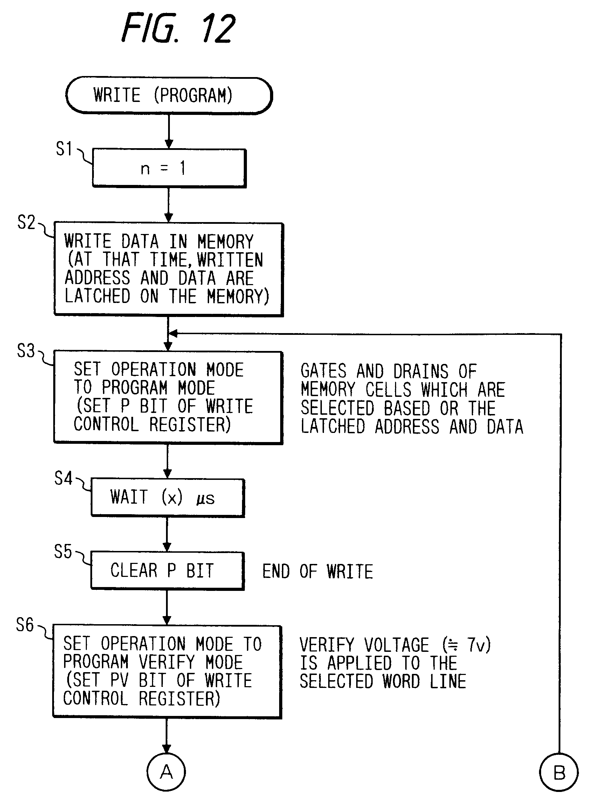

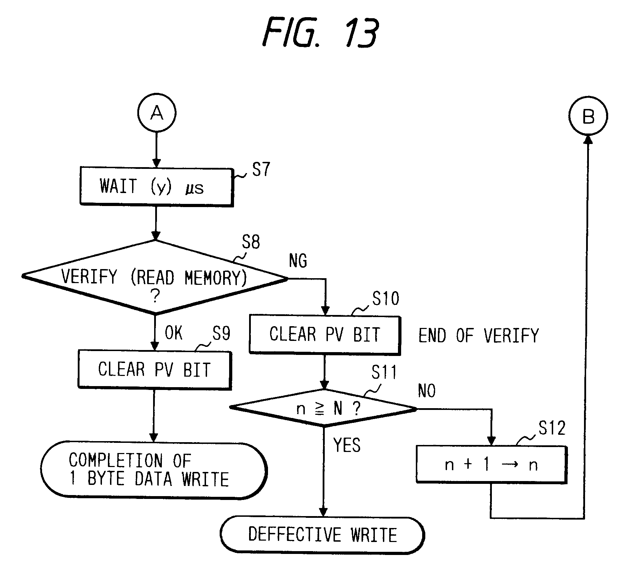

Figs. 12 and 13 illustrate write control procedures in detail. At the first step of writing data on a byte basis, for example, the main write control unit sets 1 in a built-in counter n (Step S1). Subsequently, the main write control unit sets data to be written to the flash memory FMRY in the data input latch DIL of Fig. 8 and also sets a write address in the address latches XALAT, YALAT (Step S2).

A write cycle is then issued to the write control register WREG (control register) to set a program bit P (Step S3). According to the data and the address set at Step S2, the write control circuit WCONT writes data by applying a high voltage to the control gates and drains of eight memory cells designated by the address. Then (x) µ sec. is waited for as write processing time on the part of the flash memory (Step S4) and subsequently the program bit P is cleared (Step S5). In this case, the time (x) µ sec. is determined in line with the characteristics of the memory cells and, for example, 10 µ sec. is employed.

Further, the main write control unit issues the write cycle to the write control register WREG so as to verify the write state and sets the program verify bit PV (Step S6). While utilizing the address set at Step S2, the write control circuit WCONT applies write verify voltage Vwv to a word line to be selected by the address to read the data stored in the memory cell thus written. The write control circuit WCONT waits (y) µ sec. for reading purposes Step S7.

The write verify voltage Vwv is set at a level of as high as 7 V, which is higher than the power supply voltage Vcc at, for example, 5 V. In this case, (y) sec. is determined by the rising characteristics of the write verify power supply and set, for example, to 2 µ sec. The main write control unit verifies the conformity of the data thus read with what has been used for writing (Step S8). When the conformity of the data is verified, the program verify bit PV is cleared (Step S9) and the writing of 1-byte data is completed.

The write verify voltage of 7 V may be provided by boosting the power supply voltage of 5 V or lowering a voltage of as high as 12 V. However, it is unnecessary to install a write verify voltage generating circuit in the microcomputer chip on condition that the allowable upper level of the power supply voltage is 7 V. The power supply voltage Vcc may be set to 7 V at the time of write verification.

On verifying the nonconformity at Step S8, the main write control unit clears the program verify bit PV at Step S10 and then decides whether or not the value of the counter n has reached the number of upper write retry times N (Step S11). When the number of upper write retry times N has thus been reached, the process flow is terminated as defective writing. When the number of upper write retry times N has not yet been reached, the main write control unit increments the value of the counter n by 1 (Step S12) and repeats the process starting with Step S3.

### [7] Built-in Flash Memory (2):

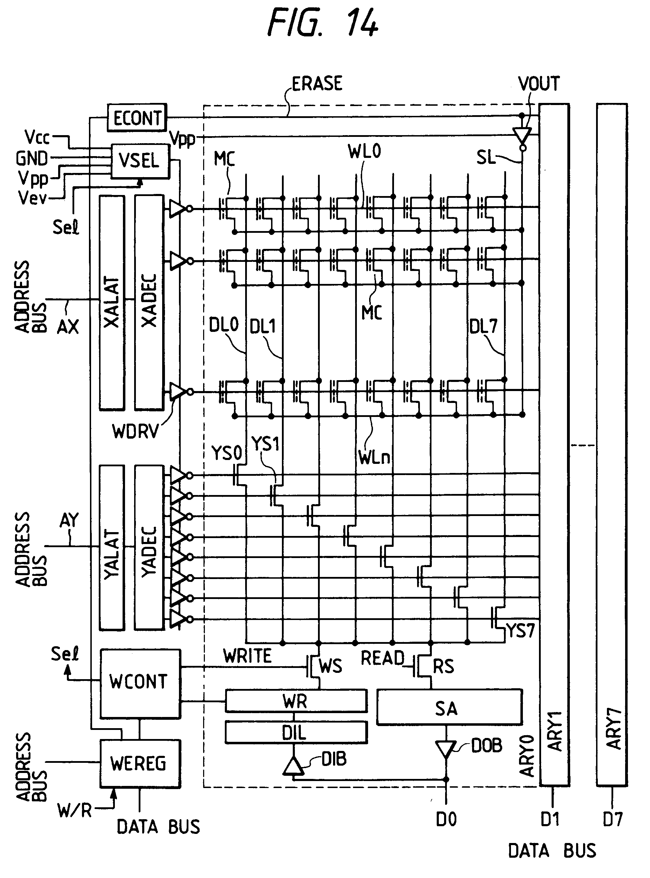

Fig. 14 is an exemplary circuit diagram of another flash memory. This circuit diagram is different from what is shown in Fig. 8 in that an erase control circuit ECONT for controlling an erase procedure is provided so as to form erase signal ERASE generating timing internally and that a write/erase control register WEREG having control bits for designating the operation of the erase control circuit ECONT. As the remaining arrangement of the circuit is similar to what is shown in Fig. 8, the description thereof will be omitted.

### [8] Erase Control (2):

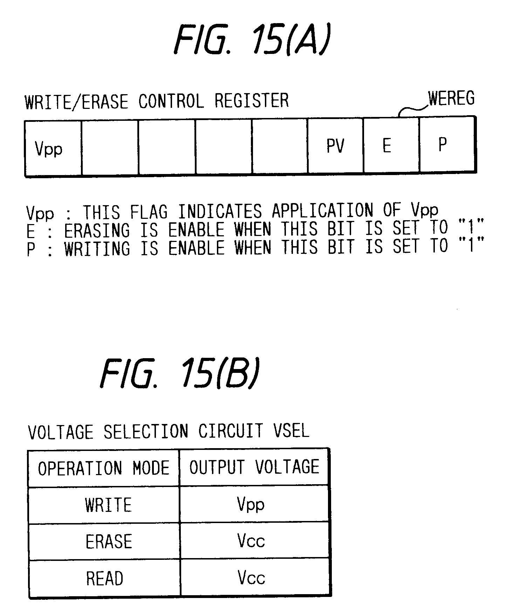

In the flash memory FMRY of Fig. 14, the erase control procedure in the test mode of the microcomputer MCU is controlled by the erase control circuit ECONT. While the erase control circuit ECONT is controlled, the write/erase control register WEREG is referred to. As shown in Fig. 15(A), the write/erase control register WEREG has an E bit in addition to the Vpp, PV and P bits. The E bit is uses for designating the erase operation. Fig. 15(B) is a table of output voltages in the respective operation modes of the voltage selection circuit VSEL. When the Vpp and E bits are set, the erase control circuit ECONT properly controls the erase and the erase verify operating procedures by reference to the Vpp and E bits. Writing data to the control register WEREG is effected by applying the address signal of the control register WEREG to the address bus, setting the write/read control signal (W/R) at a level where writing is designated and then supplying the write data to the data bus. Reading data from the control register WEREG is also effected by applying the address signal of the control register WEREG to the address bus, and setting the write/read (W/R) control signal at a level where reading is designated, whereby the data stored in the control register WEREG is supplied onto the data bus. However, the E bit is forcibly masked even in the non-test mode and prevented from being set to the enable level. The E bit can be set from the outside in only the test mode.

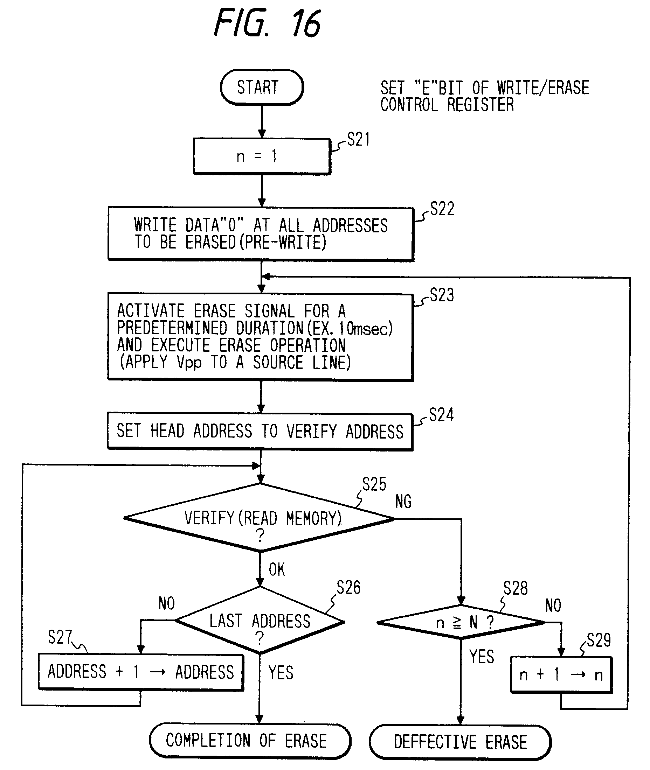

Fig. 16 is an exemplary flowchart showing erase control procedure in an erase control circuit ECONT.

First, the tester reduces all of the mode signals MD0 ^{∼} MD2 to 0 and designates the operation mode for allowing the tester to gain access directly or via the CPU to the write/erase control register WEREG of the flash memory FMRY in the test mode. Then the tester sets 1 in the CPU or its built-in counter n when effecting erasure (Step S21). The tester executes pre-writing at all addresses to be erased (Step S22), that is, writes data "0" at all addresses to be erased. The write control procedure may be applied to this pre-write control procedure. This pre-write process is performed so as to uniformize the erase state by uniformizing the whole bit of the charge quantity in the pre-erase floating gates.

Subsequently, the erase control circuit ECONT makes the ERASE signal active (high level) for a pre-determined duration, for example, 10 msec. and collectively erases all the memory cells by applying the high voltage Vpp to the source line SL of the memory cell MC (Step S23).

Then the tester internally sets the head address of the memory cell as what is to be verified to confirm the erase state (Step S24) and so verifies the address (Step S25). In other words, by executing the memory write at an address to be verified and applying the erase verify voltage to a word line to be selected at the address, the data in the erased memory cell is read out. In this case, the erase verify voltage is set at 3.5 V, which is lower than the supply voltage Vcc at 5 V, for example, to ensure a satisfactory erase level. The tester thereby verifies whether the data thus read conforms to what has completely been erased.

When the tester 10 verifies the above conformity through the verify operation, it decides whether the verified address is the last address of the memory address thus erased (Step S26) and if it is the last address, a series of erase operations is terminated. If it is decided that the last address has not yet been reached, the verified address is incremented by one (Step S27) and the process starting with Step S25 is repeated.

When the tester otherwise verifies the disparity through the verify operation at Step S25, it decides whether or not the value in the counter n successively reaches the number of upper limit erase times N (Step S28). If the number of upper limit erase times N has been reached sequentially, the step in the flowchart is terminated as defective erase, whereas if the number of upper limit erase times N has not yet been reached sequentially, the tester increments the counter value n by one (Step S29) and repeats the process starting with the step S23.

In order to prevent excessive erasure in which it may make negative the threshold voltage value of the memory cell, erasure is made successively at a time of as short as 10 msec. while verification is effected every time.

The write control procedure in the test and non-test modes with respect to the flash memory of Fig. 14 is conducted in a manner similar to what has been described with reference to Figs. 12 and 13.

The present invention as set forth above has the following effect:
(1) Erasure and writing are electrically guaranteed in the test mode by incorporating the flash memory FMRY and making the user specification One-Time Programmable (OTP). It is therefore possible to electrically test writing to the built-in flash memory a plurality of times. In comparison with the microcomputer incorporating the one-time programmable EPROM which allows only ultraviolet-ray erasure, the microcomputer according to the present invention is easy to use in the test mode and the writing test can be made after the microcomputer chip has been sealed in a package.
(2) Since only writing is allowed in the non-test mode, it is only required to guarantee writing several times even in the test mode and this makes it possible to exclude a circuit arrangement to cope with the data-line disturbance. Further, no selective screening or acceleration tests are required with respect to the flash memory.
(3) With respect to the erasure required in only the test mode, any user-friendly procedure need not be taken in consideration, there is provided, as shown in Figs. 8 and 9, the logic means for controlling the erase voltage application time in erasing the non-volatile memory element in proportion to the period during which the signal supplied to the predetermined external terminal I/O 1 remains in a fixed state. The scale of the erase circuit utilized in only the test mode is reduced by externally controlling a series of erase procedures.
(4) In any one of the constitutions shown in Figs. 8 and 14, it is possible to dispense with a power supply circuit for generating an erase verify voltage (about 3.5 V at which the word line is selected to read the data stored in the memory cell at the time erasure is verified) from the high voltage Vpp. As the erasure of data from the flash memory is only conducted in the test mode for the device test on the part of the manufacturer, it is only necessary to assign input terminals whose voltage corresponds to the test mode or reduce the power supply voltage Vcc.
(5) With respect to a voltage of about 7 V at which level the word line for use in reading the data stored in the memory cell at the time of write verification is selected, the built-in write verify power supply circuit can be dispensed with on condition that the voltage is directly supplied from an external power supply terminal. The circuit element may withstand, for example, 7 V as the allowable upper limit potential when the power supply voltage is set at 5 V.
(6) From (3) through (5) inclusive, it is possible to reduce the scale of the built-in flash memory as compared with a case where a free-reprogrammable flash memory is utilized many times as a built-in non-volatile memory for use as being OTP.

The invention made by the present inventors has been described in a concrete term. However, the present invention is not limited to the embodiments above but may needless to say be modified in various ways without departing the spirit and scope of the present invention. For example, a part of the memory array may be based on the OTP specification, though the whole of the flash memory has been based on the OTP specification in the embodiment above. In other words, a plurality of memory blocks may be formed with the source line for common use and only a part of them is formed as set forth above, so that a repetitively-reprogrammable portion is formed by arranging the OTP specification in conformity with what is shown in Fig. 8, for example, to prevent the E bits from being masked in the non-test mode as shown in Fig. 14.

Although a description has been given of a case where the invention made by the present inventors is applied to the microcomputer sealed in the flat package with pins pitched as fine as 0.5 mm or less in the field of application as the background thereof, the present invention is not limited to that field of application but applicable to any other microcomputer properly sealed in a package.

The effect achievable by an exemplary embodiment of the present invention disclosed in the present application includes the following:
(1) It is possible to electrically test writing to the built-in flash memory a plurality of times to guarantee erasure and writing electrically in the test mode. In comparison with the microcomputer incorporating the one-time programmable EPROM which allows only ultraviolet-ray erasure, the microcomputer according to the present invention is easy to use in the test mode. Moreover, the writing test can be made after the microcomputer chip has been sealed in a package.
(2) Since only writing is allowed in the non-test mode, it is solely necessary to guarantee writing several times even in the test mode. Therefore, a circuit arrangement to cope with the data-line disturbance can be dispensed with.
(3) Since any user-friendly procedure need not be taken into consideration with respect to the erasure required in only the test mode, there is provided the logic means for controlling the erase voltage application time in erasing the non-volatile memory element in proportion to the period during which the signal supplied to the predetermined external terminal remains in a fixed state. The scale of the erase circuit utilized in only the test mode can thus be reduced by externally controlling a series of procedures for applying the erase voltage.
(4) In reference to (2) and (3), the area occupied by the on-chip flash memory can also be reduced as the user specification is made one-time programmable. Therefore, the microcomputer is made less costly because the chip area of the microcomputer incorporating the flash memory is reduced.

## Claims

1. A one-chip type microcomputer comprising:
external terminals (10) for receiving mode signals,
a flash memory (FMRY) including a plurality of electrically erasable and programmable non-volatile memory elements (MC) adapted to be made erasable and reprogrammable by writing when the mode signals designate a test mode, and to be made programmable when the mode signals designate a non-test mode, and
a central processing unit (CPU) capable of gaining access to the flash memory (FMRY).

2. The microcomputer of claim 1, further comprising:
logic means (11) for controlling the erase voltage application time in erasing the non-volatile memory elements (MC) in proportion to a period during which a signal supplied to a predetermined external terminal (15) remains in a fixed state.

3. A one-chip type microcomputer comprising:
external terminals (10) for receiving mode signals,
a flash memory (FMRY) including a plurality of electrically erasable and programmable non-volatile memory elements, all of which adapted to be made erasable and reprogrammable by writing when the mode signal designates a test mode, and part of which are adapted to be made programmable when the mode signals designate a non-test mode, and
a central processing unit (CPU) capable of gaining access to the flash memory (FMRY).

4. The microcomputer of claim 3, further comprising:
write control means (WCONT) for controlling a series of procedures for writing to the plurality of non-volatile memory elements (MC) and a write control register (WREG) for designating the operation of writing to the write control means (WCONT).

5. The microcomputer of claim 3, wherein the flash memory (FMRY) includes word lines (WL0...WLn), data lines (DL0...DL7) and source lines (SL) wherein
each of the plurality of the non-volatile memory elements (MC) has a control gate connected to a word line (WL...), the drain connected to a data line (DL...) and the source connected to the source line (SL), and wherein
when writing data to the non-volatile memory elements (MC), the non-volatile memory element placed in the word-line non-select state and the data-line select state undergoes data-line disturbance resulting from the injection of hot holes from the drain to the floating gate as a relatively greater electric field acts across the source drain.

6. A microcomputer sealed in a package and having a plurality of external terminals (10, 12...14), the microcomputer including:
a central processing unit (CPU), and
a program memory (FMRY) coupled to the central processing unit (CPU) and used for storing programs to be executed by the central processing unit (CPU), wherein
the plurality of the external terminals (10, 12...14) are 0.5 mm or less spaced apart, wherein
the program memory is a flash memory (FMRY) including electrically erasable and programmable non-volatile memory cells (MC), and wherein
the program memory is of a one-time programmable type to which data can be written while the microcomputer remains in the normal operation mode.
